Europäisches Patentamt

European Patent Office

Office européen des brevets

(11) Publication number: 0 309 294 A2

# EUROPEAN PATENT APPLICATION

(21) Application number: 88308904.7

(22) Date of filing: 26.09.88

(51) Int. Cl.⁴: **H 01 L 39/24**
H 01 J 37/34, C 23 C 16/40

(30) Priority: 24.09.87 JP 241875/87
24.09.87 JP 241876/87

(43) Date of publication of application:
29.03.89 Bulletin 89/13

(84) Designated Contracting States: DE FR GB

(71) Applicant: SEMICONDUCTOR ENERGY LABORATORY CO., LTD.
398 Hase
Atsugi-shi Kanagawa-ken, 243 (JP)

(72) Inventor: Yamazaki, Shunpei
21-21 Kitakarasuyama 7-chome Setagaya-ku
Tokyo (JP)

(74) Representative: Milhench, Howard Leslie et al
R.G.C. Jenkins & Co. 26 Caxton Street
London SW1H 0RJ (GB)

(54) Method and apparatus for the manufacture of superconducting oxide materials.

(57) A sputtering apparatus for producing a thin film of a superconducting oxide material comprises a pair of sputter targets of compacted superconducting material which are mutually separated and opposed to each other so as to define a region wherein a substrate which is required to be coated with sputtered material may be located, and means for subjecting such substrate to the action of a magnetic field oriented perpendicular to or parallel with the substrate surface whereby crystal orientation is caused to occur during the growth of the film.

F I G. 2

**Description**

## Method and Apparatus for the Manufacture of Superconducting Oxide Materials

BACKGROUND OF THE INVENTION

Field of the Invention

The present invention relates to the manufacture of superconducting oxide materials and more particularly to a method and an apparatus for manufacturing a thin film superconducting oxide ceramic material.

Description of the Related Art

Recently, superconducting ceramic materials have been attracting a great deal of attention. These materials were first reported by IBM's Zurich Laboratories in the form of Ba-La-Cu-O (BALACUO) type high temperature superconducting oxides. In addition, YBCO ($YBa_2CuO_{6-8}$) type materials are also known. However, these types of materials could be prepared only by mixing and firing various types of oxide powders to form tablets, so that even when a Tc onset of 90 K was obtained, it was not possible to obtain a thin film of the superconducting material.

The critical current density of these polycrystalline superconducting oxide structures in tablet form is small. In order to correct this problem, it is desired that all the ab planes of the crystal grains (also referred to as the C planes, namely the planes perpendicular to the c axis direction) be mutually oriented, that is to say aligned all in at least substantially the same direction.

Furthermore, it is strongly desired that the Tco (temperature at which resistance is zero) of the superconducting oxide material be higher. It is desirable that operation be possible at the temperature of liquid nitrogen (77 K) or a higher temperature, and that, in turn, a Tco temperature of 90 K or higher be available in the structure of the thin film.

With such objectives in mind, we made the invention which is described in our European Patent Application No. 88302512.4 (EP-A-0284354) and which concerns a method and apparatus for manufacturing a superconducting material wherein a magnetic field is applied to the material during a heating stage in its formation process. The present invention is a further development of the abovementioned invention.

SUMMARY OF THE INVENTION

In accordance with the present invention a sputtering method is used to produce a thin film of a superconducting oxide material. A pair of spaced apart targets are arranged facing each other, and a magnetic field is applied between the targets. A substrate having a film-forming surface portion is placed in the magnetic field and sputtering is effected so as to deposit superconducting oxide material onto the film-forming surface portion with the crystals of the superconducting oxide material oriented parallel to or perpendicular to the film-forming surface portion in dependence upon the orientation of the film-forming surface portion relative to the magnetic field. A device based on the crystal anisotropy of the superconducting oxide material can easily be produced which has the capability of supporting a high current density.

As will be described hereinafter, the present invention enables the formation of a thin film superconducting oxide material at a relatively low temperature, and with the superconducting material having a preferred crystal orientation. Not only does the increased orderliness of the crystal orientation of the deposited film present advantages as regards the current density that can be carried by the superconductor and as regards its Tc and Tco temperatures, but also since the film formation can be effected at relatively low temperatures it becomes possible to utilize the film as a conductor portion in an electronic integrated circuit without giving rise to undesirable oxidation effects between the oxygen rich superconducting material and the underlying semiconductor material of the integrated circuit.

Further features of the invention are set forth in the appended claims and, together with the above-described features, will become more apparent from consideration of the following description of exemplary embodiments taken in conjunction with the accompanying drawings.

BRIEF DESCRIPTION OF THE DRAWINGS

FIG.1 is a diagram showing the crystal structure of an exemplary superconducting oxide material which can be produced by the present invention;

FIG.2 is a diagram showing an exemplary sputtering apparatus according to the present invention; and

FIG.3 and FIG.4 are diagrams showing modifications of parts of the embodiment of the present invention shown in FIG.2.

DETAILED DESCRIPTION OF THE EMBODIMENTS

As described hereinafter, a sputtering apparatus for producing a thin film of a superconducting oxide material according to the present invention has two targets which are mutually separated and facing each other, and a magnetic field is applied between the targets. A substrate having a film-forming surface portion upon which a superconducting film is to be deposited is placed between the two targets with its film-forming surface portion parallel or perpendicular to the magnetic field so that by subjecting the film-forming surface portion to the direct action of the magnetic field crystal orientation is caused to occur during the growth of the film.

When a superconducting thin film is cooled down to its activation temperature, that is to say the temperature at which it exhibits superconductivity, cracks are likely to occur because the coefficients of thermal expansion of the substrate and of the thin film are different to each other. However, in the practice of the present invention, the thin film is formed at such a low temperature, between room temperature and 500°C for example, that cracking does not take place, and even at such a low temperature single crystals or polycrystals with their crystal axes oriented in a preferred direction can be fabricated.

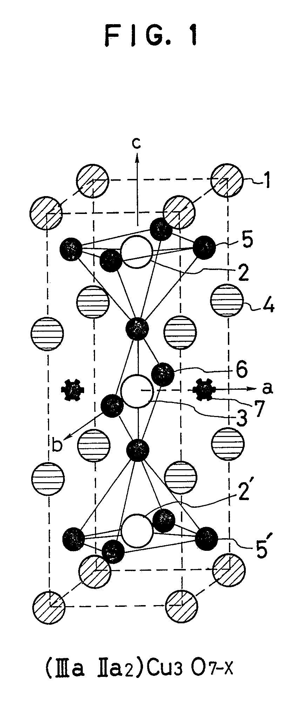

Furthermore, when a crystalline thin film of superconducting oxide material having a modified perovskite structure as shown in Fig.1 is produced in accordance with the teachings of the present invention, the a,b, or c axes of the crystal structure are oriented parallel or roughly parallel to a desired direction when the film-forming surface portion is directly subjected to the magnetic field which, incidentally, may also be used for plasma generation to carry out the required sputtering or the like. By means of this magnetic field, the growth surfaces of the crystals are positioned in a uniform direction, and magnetic axial growth occurs. In addition, in the case where single crystals are grown, magnetic epitaxial growth occurs.

As a result, during the formation of a thin film by the simultaneous application to the film-forming surface portion of a strong magnetic field of 0.1 T or more, and preferably 0.2 to 3 T, used for plasma creation, it becomes possible to form a uniformly oriented film on the film-forming surface portion at a lower temperature than has heretofore been possible, preferably from room temperature to about 500°C. Simultaneously, reactive gases or particles which are sputtered from the target are subjected to a plasma reaction in active oxygen or a gas containing active oxygen generated in the plasma, and the reaction product forms a polycrystalline superconducting oxide material film on the film-forming surface portion with the axes of the crystals uniformly oriented in a preferred direction. By virtue of this, the critical current density in the direction of, for example, the c plane (the plane parallel to the ab axes, specifically the ab plane) may be improved to 1 x $10^5$ A/cm$^2$ or greater (in this case, the ab surface can be in a direction parallel to the surface of the substrate).

A representative superconducting oxide material which may be used in the practice of the present invention is an oxide using elements in Group IIa and Group IIIa of the Japanese Periodic Table and copper. For the avoidance of doubt it is to be noted that all references herein and in the appended claims to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIa and VIIa of the Japanese Periodic Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa, IVa, Va, VIa and VIIa of the European Periodic Table.

An exemplary superconducting material which may be used in the practice of the present invention can be generally represented by the expression $(A_{1-x}B_x)_yCu_zO_w$, where x = 0.1 to 1, y = 2.0 to 4.0, preferably 2.5 to 3.5, z = 1.0 to 4.0, preferably 1.5 to 3.5, and w = 4.0 to 10.0, preferably 6 to 8. One representative example is a material having a modified perovskite structure represented by the expression $AB_2Cu_3O_{6-8}$, where A is one or more elements of the yttrium group and the other lanthanides, the yttrium group being defined as the group containing Y (yttrium), Gd (gadolinium), Yb (ytterbium), Eu (europium), Tb (terbium), Dy (dysprosium), Ho (holmium), Er (erbium), Tm (thulium), Lu (lutetium), Sc (scandium), and other lanthanides, and B being one or more of the group of Ba (barium), Sr (strontium), and Ca (calcium). An example of such a superconducting oxide material comprises $(YBa_2)Cu_3O_{7-x}$ which, as shown in Fig.1, has a modified perovskite structure. It has a plane including a copper atom (2) and four neighboring oxygen atoms (5), another plane including a copper atom (3), two oxygen atoms (6) positioned next to it, and two oxygen vacancies (7), and a third plane similar to the first and comprising a copper atom (2') and four oxygen atoms (5'). Reference numeral (1) is an element from Group IIIa of the Japanese Periodic Table, in the present example Y, and reference numeral (4) is an element from Group IIa of the Japanese Periodic Table, in the present example, Ba.

The inventor of the present invention suggests as the mechanism which creates superconductivity that by means of the mutual action of oxygen (5), (5') in a layer structure and copper (2), (2') at the center of the layer, electrons which are paired (electron pairs) can move in ab planes, that is to say planes perpendicular to the c axis of the crystal. Up to this time, mutual action with a phonon has been considered to be the cause of the formation of the paired electrons, based on the BCS (Bardeen-Cooper-Schrieffer) theory. However, the inventor of the present invention suggests. that a quasiparticle known as a magnon is created when an oxygen vacancy (7) within the layer structure of Fig.1 is associated with another oxygen vacancy in the atomic system positioned on the upper or lower side of the diagram or with a rare earth element (1), which is a screw magnetic body, and that the quasiparticle acts as an intermediary to form a pair of electrons spinning in opposite directions. The magnon fluctuates in the c axis direction, this direction favouring the production of electron pairs, and causes the attraction of an otherwise mutually repelling pair of electrons having opposite spin directions. The magnon is not completely in evidence but works behind the scenes. The resulting electron pairs move within the ab planes within the laminar crystal structure, namely the plane including the atoms (2), (5) and the plane including the atoms (2'), (5'). This can be considered as the cause of superconductivity. In addition, it is possible to consider the fluctuations of the oxygen vacancy as a phonon fluctuation, and therefore to have a pattern which supplements the BCS theory and in which it can be considered that the phonon, through the medium of the magnon, indirectly causes the electron pair to form.

Because the magnetic effects are paramount in this explanation of superconductivity, the present invention can take advantage of the application of a strong magnetic field to a plasma atmosphere generated between the targets during film formation so that most, and desirably all, of the diamagnetic crystals being deposited are uniformly aligned in the prescribed direction conforming to the direction of the magnetic field.

In an embodiment of the present invention, a pair of separated opposing targets of superconducting oxide material are provided as aforementioned and a plasma is produced between the two targets using a mixed gas of argon and oxygen. Then, using this plasma, the targets are subjected to a sputtering process and a superconducting oxide material is formed on the film-forming surface portion of a substrate positioned between the two targets. During film formation a magnetic field is applied to the space between the two targets so that one becomes a north pole while the other becomes a south pole. By virtue of this arrangement, a magnetic field is applied in the space between the targets at right angles to the target surfaces, and a film of superconducting oxide material is easily formed with its c axis conforming to this magnetic field.

A polycrystalline film can be formed in accordance with the practice of the invention in which the respective crystal axes of the crystals forming the thin film are substantially uniformly oriented. Furthermore, by using a substrate in which the surface on which film deposition occurs has a crystal orientation aligned with the desired orientation of the deposited film, magnetic epitaxial growth leading to the formation of a quasi-single-crystal thin film can be obtained.

The mechanism of this is that a crystal particle developing into a polycrystal can become larger. In turn, because adjacent crystals have the same crystal axis orientation, the barriers at the crystal boundaries have a tendency to disappear, and a structure equivalent to that of a single crystal can be obtained wherein the respective crystals can all become adjusted at their ab surfaces (the surface perpendicular to the c axis). By this means, a superconducting oxide material having a quasi-single-crystal structure can be obtained at a relatively low temperature of 500°C or less. Electric current can flow in the C surface in Fig.1 (the surface parallel to the ab axes) in an amount 100 or more times the flow obtainable in the perpendicular direction (c axis direction), and for this reason, when using a polycrystalline superconductor, it is extremely important that the crystal orientations of the polycrystals be arranged all in one direction in order to obtain a high critical current density. By the method of the present invention, the critical current density, which up to the present has been of the order of $10^2$ A/cm$^2$ (77K) in the case of random cyrstal orientation, can be increased up to $10^4$ to $10^6$ A/cm$^2$ (measured at 77K) with the current flowing parallel to the ab surface, and can become equal to the current density obtainable in a single crystal or at least close to about one fifth of the single crystal level which is still relatively high. As thus described, the invention makes it easier to make a thin film single crystal structure of large area which is ideal for a superconducting oxide material.

In addition, by use of substrates which have different crystal orientations in their film-forming surface portions, the application of the magnetic field can achieve different film orientations conforming to the direction of arrangement of the substrate crystals. For example, if a (100) crystal substrate for example of MgO (magnesium oxide), $SrTiO_3$ (strontium titanium oxide), or YSZ (yttrium stabilized zircon) is used, and the magnetic field is applied in the direction perpendicular to the film-forming surface portion, a film can be created in which the ab surface is parallel to the film-forming surface portion. If crystal substrates which have a (110) surface are used and the magnetic field is applied parallel to the film-forming surface portion, it is possible to obtain a film having its ab surface perpendicular to the film-forming surface portion during film-forming or during heat and magnetic field annealing after the film is formed.

Having discussed the invention in general terms in the foregoing, specific exemplary embodiments of the invention will now be described.

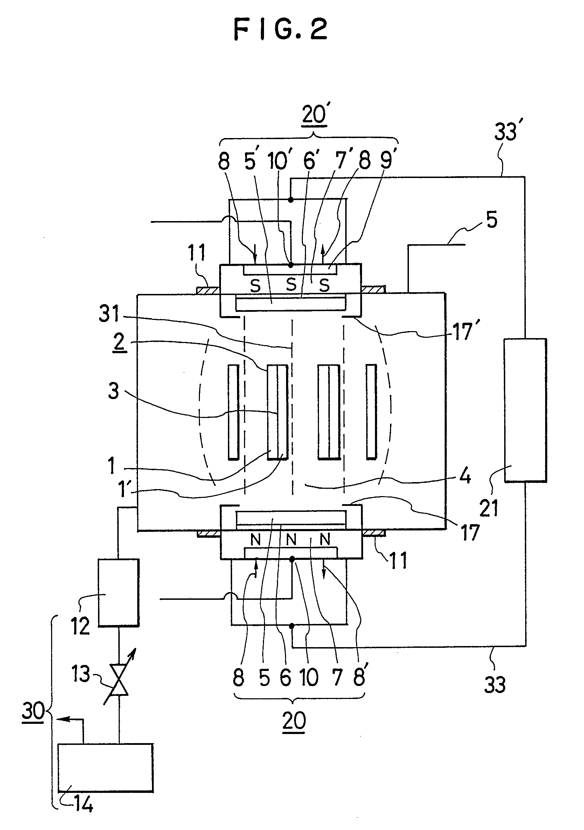

Referring to FIG.2, this drawing shows a sputtering apparatus according to the present invention for use in manufacturing a superconducting oxide material. The apparatus comprises a pair of target systems 20, 20' in mutual opposition, a magnetic field generating space 4, a doping system 25, an exhaust gas system 30, and a magnetic field circuit comprising a north magnet 7 and a south magnet 7' coupled by magnetic members 33,33' which form a magnetic circuit of low magnetic resistance outside of the magnetic field generating region to a coil 21 for generating the magnetic field, thus making it possible to produce a strong magnetic field 31 preferably of 0.1 T or greater, within the space 4. The doping system 25 is only schematically illustrated and serves for introducing a gas comprising argon, oxygen, and other elements used as additives into the reaction space 4. The exhaust gas system 30 comprises a turbomolecular pump 12, a pressure regulating valve 13, and a rotary pump 14.

A pair of substrates 1,1' are positioned in intimate contact at their rear surfaces 3 with a holder (omitted from the drawing) which also serves as a heater. The substrates 1,1' can be heated from room temperature up to a maximum of 800°C in the described apparatus, though in the practice of the present invention heating from room temperature to 500°C is adequate to form a thin film and the forming of the film generally takes place at room temperature. The drawing shows the case where the film-forming surface portions of the substrates 1,1'

are positioned in parallel with the magnetic field 31 betweent he opposing target systems 20,20'.

The target systems 20,20' include targets 5,5' comprised of a compressed superconducting oxide material represented by the expression $(A_{1-x}B_x)_yCu_zO_wX_v$, where $x = 0.1$ to 1.0, $y = 2.0$ to 4.0, $z = 2.0$ to 4.5, and $w = 4.0$ to 8.0. These targets contain 20% excess copper to satisfy the stoichiometric ratio. The distance between the targets 5,5' is 10 to 25cm, and the substrates are positioned in a region between the targets where a magnetic field of the order of 0.3 T exists. Disposed on the reverse side of the targets 5,5' respectively are a pair of packing plates 6,6', a pair of magnetic pole pieces 7,7', a cooling water inlet 8, a cooling water outlet 8', and a pair of shield plates 17,17'. These assemblies are electrically isolated from the body of the sputtering apparatus by a teflon insulating body 11. A pair of current introducing terminals 10,10' are provided for applying a negative high voltage (in the case where the substrates are grounded electrodes) to the targers 20.20'. Alternatively with the substrate grounded, a negative high voltage may be applied to one target and a positive high voltage to the other target, so that a complementary alternating voltage may be applied.

In accordance with a first exemplary application of an apparatus as shown in Fig.2, a material represented by the expression $YBa_2Cu_{3-3.6}O_{6-8}$ was used as the targets 5,5'. The distance between the targets 5,5' and the substrates was 20cm. Six sheets of 10cm x 10cm square substrates were positioned in the middle section between the targets 5,5'. The argon pressure was $4 \times 10^{-1}$ Pa, and the oxygen pressure $5 \times 10^{-3}$ Pa. The DC sputtering output ranged from 500 w to 1 KW. The targets 5,5' were rectangular with one side being 30cm in length. The substrates 1,1' were kept at room temperature, and the adjacent magnetic field 31 was 0.3 T. Under such conditions a superconducting oxide material 2 was formed at a film forming speed in the range of 10 to 100 Å/min, for example, 40 Å/min on the film-forming surface portions of the substrates 1,1'. Following this, plasma oxidation annealing under the application of a magnetic field was carried out on all of the substrates in another chamber which is omitted from the drawing but may be positioned on either the right or the left side of the sputtering chamber and is connected to the reaction chamber 4. Annealing was carried out for 8 hours at 200 to 450°C, followed by cooling. A superconducting oxide material was obtained with a Tco of 96 K and a critical current density of $3 \times 10^5$ A/cm² measured at 77 K).

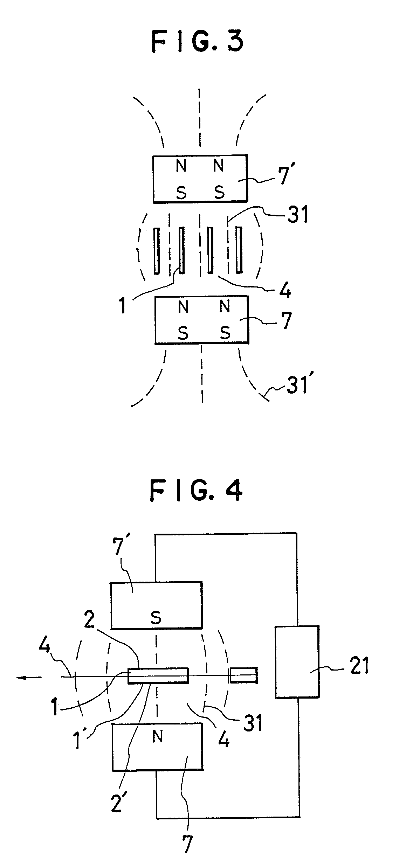

In accordance with a second exemplary application of an apparatus as shown in Fig.2, one of the targers 5,5' was formed of a material represented by the expression $YBaCu_{3-4}O_{6-8}$ and the other was formed of a material represented by the expression $YbSr_2Cu_{3-4}O_{6-8}$. A film represented by the expression $Y_{0.5}Yb_{0.5}BaSrCu_3O_{6-8}$ was formed. The argon pressure was $4 \times 10^{-1}$ Pa, and the oxygen pressure was $1 \times 10^{-2}$ Pa. In this case, the magnets 7,7' were permanent magnets of rare earth type, and as shown in Fig.3 these magnets formed a divergent magnetic field 31' outside of the magnetic field generating region 4. For this reason, even using a rare earth type magnet, a magnetic field strength of only about 0.01 T could be obtained. In spite of this fact, a superconducting oxide material was obtained under the effect of this magnetic field. The parts not shown in Fig.3 were the same as in FIG.2. Under these conditions it was possible to produce a material represented by the expression $Y_{0.5}Yb_{0.5}Ba_2Cu_3O_{6-8}$. As much as 90% of the polycrystals in the material obtained were aligned with their c axes oriented at least roughly parallel to the film-forming surface portion (within ± 30 deg. of the c axis).

FIG.4 is a schematic showing of another embodiment of the present invention. In this embodiment, the substrate holders are differently oriented so that the substrates 1,1' have their film-forming surface portions arranged perpendicular to the magnetic field 31. By virtue of this arrangement, the c axis of the superconducting oxide material film 2,2' that is obtained is oriented at right angles to the substrate. It was possible to generate a magnetic field of 0.6 T and obtain a thin film of a thickness of 3 μm by use of a magnetic field generating means 21 comprising a superconducting coil with a magnetic circuit of low magnetic resistance formed outside of the region 4. Otherwise the embodiment of Fig.4 was as the Fig.2 embodiment.

In an exemplary application of the Fig.4 apparatus, a material represented by the expression $YBaSrCu_3O_{6-8}$ was used as the sputtering target. By virtue of the invention, it was possible to form a thin film of superconducting oxide material having its c axis oriented perpendicular to the film-forming surface portion of the substrate and its ab plane parallel to the film-forming surface portion. A critical current density of $1.7 \times 10^5$ A/cm² was obtained for a superconducting oxide material thin film formed on a film-forming surface portion of, for example, polycrystals of glass, alumina, $ZrO_2$ or the like or an amorphous structure on the substrate. A Tco of 93 K was obtained.

In another application of the invention, the substrate used was a single crystal of MgO (100) or $SrTiO_3$ (100). A magnetic field of 2T was applied throughout film-forming on the film-forming surface portion, and the substrate temperature was maintained at 450°C. A single crystal thin film of 1 cm² or greater in area and 3.5 μm thickness was obtained on the substrate. A critical current density of $2.7 \times 10^6$ A/cm² (77 K) and a Tco of 98 K were obtained.

In yet another application of the invention, the substrate used was a single crystal of MgO (110) or $SrTiO_3$ (110). A magnetic field of 2T was applied at the film-forming surface portion, and the substrate temperature was maintained at 450°C. A single crystal thin film of about 5 mm² in area and 3 μm thickness was obtained on the substrate. A critical current density of $1.9 \times 10^6$ A/cm² in a direction parallel to the ab surface and a Tco of 97 K were obtained.

In summary, by the use of the present invention as described in the foregoing it has become possible to create a thin film superconducting oxide material having uniformly oriented crystal axes which operates at the temperature of liquid nitrogen or higher. It is also possible to make an oriented polycrystal superconducting oxide film on the surface of a substrate comprising an amorphous structure of glass, silicon oxide, silicon nitride or the like. In the case where the growth of the crystal structure is in a direction conforming to the substrate crystal axis, it is possible for the first time to utilize this superconducting material as a lead wire at the electrode section of a semiconductor integrated circuit in which contact between the semiconductor and the superconductor can be effected without a disadvantageous direct oxidizing reaction because an oriented film can be obtained at a relatively low substrate temperature between room temperature and 500°C.

In addition, the invention enables superconducting materials comprising mixtures of various elements from Groups IIa and IIIa of the Japanese Periodic Table to be obtained, so that it is easier to form a laminated structure comprising polycrystalline compounds of the materials obtained in this manner. As shown in the present invention, because a more uniform molecular arrangement can be obtained by applying a magnetic field during heating, it is possible to eliminate voids within the crystals and to reduce the effect of crystal grain barriers in the final compound, and in turn it is to be assumed that a higher Tco can be obtained.

In the embodiments of the present invention described in the foregoing, the magnetic field generating source was provided to the rear of the targets. However, it is also acceptable for the magnetic field to be generated by the provision of a cylindrical air core section and by means of an electric magnet enclosing the space between the vertical targets as is shown in FIG.2. It is also acceptable to apply the magnetic field between a pair of targets having their NS orientation perpendicular to the target direction (the lateral direction in FIG.2), and not facing in the same direction as the targets. In addition, this magnetic field may be a rotary magnetic field.

The superconducting materials that can be used in accordance with the teachings of the present invention are not to be regarded as limited to the structure shown in FIG.1. The present invention is applicable to any superconducting material which can respond to an applied magnetic field, and therefore, to any magnetic superconducting material.

Superconducting ceramics also may be prepared in accordance with the present invention in consistence with the stoichiometric formula $(A_{1-x}B_x)_yCu_zO_w$, where A is one or more elements of Group IIIa of the Japanese Periodic Table, e.g., the rare earth elements, B is one or more elements of Group IIa of the Japanese Periodic Table, e.g., the alkaline earth metals including beryllium and magnesium, and $0 < x < 1$; $y = 2.0$ to $4.0$, preferably $2.5$ to $3.5$; $z = 1.0$ to $4.0$, preferably $1.5$ to $3.5$; and $w = 4.0$ to $10.0$, preferably $6.0$ to $8.0$. Also, superconducting ceramics for use in accordance with the present invention may be prepared to be consistent with the stoichiometric formula $(A_{1-x}B_x)_yCu_zO_w$, where A is one or more elements of Group Vb of the Japanese Periodic Table such as Bi, Sb and As, B is one or more. elements of Group IIa of the Japanese Periodic Table, e.g., the alkaline earth metals including beryllium and magnesium, and $x = 0.3$ to $1$; $y = 2.0$ to $4.0$, preferably $2.5$ to $3.5$; $z = 1.0$ to $4.0$, preferably $1.5$ to $3.5$; and $w = 4.0$ to $10.0$, preferably $6.0$ to $8.0$. Examples of this general formula are $BiSrCaCu_2O_x$ and $Bi_4Sr_3Ca_3Cu_4O_x$. Tc onset and Tco for samples confirmed to be consistent with the formula $Bi_4Sr_yCa_3Cu_4O_x$ (wherein y was around 1.5) were measured to be 40 to 60 K, which is not so high. Relatively high critical temperatures were obtained with samples conforming to the stoichiometric formulae $Bi_4Sr_4Ca_2Cu_4O_x$ and $Bi_2Sr_3Ca_2Cu_2O_x$ wherein the number x designating the oxygen proportion was from 6 to 10, e.g. around 8.1.

## Claims

1. An apparatus for manufacturing a superconducting oxide material by sputtering, said apparatus comprising:

first and second spaced-apart sputtering targets provided in a sputtering chamber in mutual opposition; means for supporting an object having a film-forming surface portion on which a superconducting oxide material is required to be formed; and

means for creating a magnetic field between the two targets;

and wherein the film-forming surface portion is positioned in the magnetic field so as to expedite the formation of a superconducting oxide material.

2. The apparatus of Claim 1, wherein the superconducting oxide material is oriented on the film-forming surface portion in accordance with the direction of the magnetic field.

3. The apparatus of Claim 1 or 2, wherein means are provided for defining a closed magnetic circuit in a region outside of the space between the two targets, so that a plasma developed between the two sputtering targets may be concentrated by the magnetic field to form a high density plasma.

4. The apparatus of any preceding Claim, wherein the superconducting oxide material is generally represented by the expression $(A_{1-x}B_x)_y Cu_zO_w$, where $x = 0.1$ to $1$, $y = 2.0$ to $4.0$, $z = 1.0$ to $4.0$, and $w = 4.0$ to $10.0$, A is at least one member selected from the group comprising Y (yttrium), Gd (gadolinium), Yb (ytterbium), Eu (europium), Tb (terbium), Dy (dysprosium), Ho (holmium), Er (erbium), Tm (thulium), Lu (lutetium), Sc (scandium) and other lanthanides, and B is at least one member selected from the group of Ba (barium), Sr (strontium) and Ca (calcium).

5. A method of manufacturing a superconducting oxide material, said method comprising:

providing a target having a surface portion on which a superconducting oxide material is to be formed;

creating a magnetic field in the region of the target so that the said surface portion thereof is subjected to the action of the magnetic field; and

sputtering superconducting oxide material on to the said surface portion so that a film of the superconducting oxide material is formed on said surface portion with a crystalline orientation determined by said magnetic field.

6. The method of claim 5, wherein the said surface portion is oriented parallel to the magnetic field, whereby the superconducting oxide material that is formed on the target has its c axis parallel to said surface portion.

7. The method of claim 5, wherein the said surface portion is oriented perpendicular to the magnetic field, whereby the superconducting oxide material that is formed on the target has its c axis perpendicular to said surface portion.

8. The method of any of Claims 5 to 7 wherein the superconducting material is generally represented by the expression $(A_{1-x} B_x)_y Cu_z O_w$,

where $x = 0.1$ to $1$, $y = 2.0$ to $4.0$, $z = 1.0$ to $4.0$, and $w = 4.0$ to $10.0$, A is at least one member selected from the group comprising Y (yttrium), Gd (gadolinium), Yb (ytterbium), Eu (europium), Tb (terbium), Dy (dysprosium), Ho (holmium), Er (erbium), Tm (thulium), Lu (lutetium), Sc (scandium), and other lanthanides, and B is at least one member selected from the group comprising Ba (barium), Sr (strontium) and Ca (calcium).

9. An apparatus for the formation of a film of superconducting material by sputtering and wherein the deposition of the sputtered material upon a substrate surface is effected under the action of a magnetic field so as to provide the deposited material with a preferential magnetic orientation.

10. A method of depositing a film of superconducting material by sputtering, said method including the utilization of a magnetic field to obtain a preferential orientation of the deposited material.

# F I G. 1

$(\mathrm{III}a\ \mathrm{II}a_2)\mathrm{Cu}_3\,\mathrm{O}_{7-x}$

# FIG. 2

# FIG. 3

# FIG. 4